# EUROPÄISCHE PATENTSCHRIFT

(11) **EP 0 349 911 B1**
(45) Veröffentlichungstag und Bekanntmachung des Hinweises auf die Patenterteilung: **20.09.1995**
(21) Anmeldenummer: 89111893.7
(22) Anmeldetag: 30.06.1989
(51) Int. Cl.: H01J 37/20, G01N 27/00, B25J 7/00

(54) **Mikromanipulator**
Micromanipulator
Micromanipulateur

(30) Priorität: 03.07.1988 DE 3822504
(43) Veröffentlichungstag der Anmeldung: 10.01.1990
(73) Patentinhaber: FORSCHUNGSZENTRUM JÜLICH GMBH, 52425 Jülich (DE)
(72) Erfinder: Besocke, Karl-Heinz, D-5170 Jülich (DE); Teske, Martin, D-5160 Düren (DE); Frohn, Josef, D-5102 Herzogenrath (DE); Wolf, J. Francis, D-5170 Jülich (DE)

(56) Entgegenhaltungen:
- EP-A- 0 252 174
- EP-A- 0 252 745
- EP-A- 0 262 408
- DE-A- 3 610 540
- IBM TECHNICAL DISCLOSURE BULLETIN, Band 22, Dezember 1979, Seiten 2897-2898, Armonk, NY, US; G. BINNIG et al.: "Piezo drive with coarse and fine adjustment"

## Beschreibung

### Mikromanipulator

Die Erfindung bezieht sich auf einen Mikromanipulator zur Bewegung eines Objekts relativ zu einer Bearbeitungs- oder Analysenposition so, daß zumindest ein Teil der Objektoberfläche bearbeitet oder analysiert werden kann. Die Merkmale, von denen die Erfindung ausgeht, sind in Oberbegriffen der nebengeordneten Patentansprüche 1, 2 und 4 angegeben.

Mikromanipulatoren der vorgenannten Art sind zur Ausführung von Bewegungen bei Raster-Tunnel-Mikroskopen (RTMs) bekannt. Das RTM erfordert ein Höchstmaß an Präzision für die Bewegung des jeweils zu untersuchenden Objekts relativ zur Abtastnadel (Tunnelspitze) des RTMs.

In DE-A-36 10 540 wird ein Mikromanipulator beschrieben, bei dem zur Abstützung des zu untersuchenden Objekts mehrere Bewegungselemente aus piezoelektrischem Material benutzt werden. Die Bewegungselemente sind derart ausgebildet, daß durch Mikrobewegungen sowohl Translations- als auch Rotationsbewegungen sowie ein Kippen des Objekts möglich ist. Der beschriebene Mikromanipulator ist auf Mikrobewegungen des Objekts eingerichtet, wobei in der zu bearbeitenden Addition von Mikrobewegungen auch Makrobewegungen möglich sind. Senkrecht zur vorgenannten Objektebene sind Bewegungen nur insoweit ausführbar, als es die durch Anlegen elektrischer Spannungen erreichbare Verformung des piezoelektrischen Materials zuläßt.

Aus EP-A-0 262 408 ist ein mit einer Mikrometerschraube zur Makroverstellung kombinierter Piezotranslator bekannt. Zur Verbindung des ortsfesten Bereichs mit dem piezoelektrisch verstellbaren Bereich ist eine Feder-Parallelführung vorgesehen.

Aufgabe der Erfindung ist es, einen Mikromanipulator zu schaffen, mit dem sich in jeder Richtung mit den für die Mikrobewegung vorgesehenen Bewegungselementen zugleich auch Makrobewegungen ausführen lassen.

Diese Aufgabe wird gemäß der Erfindung bei einem Mikromanipulator der eingangs genannten Art alternativ in dreierlei Varianten gelöst: gemäß Patentanspruch 1 dadurch, daß die Auflage des Bewegungselementes in einer am Bewegungselement befestigten Buchse so gelagert ist, daß Reibkräfte zwischen einander angrenzenden Oberflächen von Auflage und Buchse eine Bewegung verhindern und zur Stütze des Objekts oder des Objekthalters ausreichend sind. Durch Anlegen von Spannungsfunktionen an das piezoelektrische Bewegungselement werden die Haftreibungskräfte zwischen Auflage und Buchse aufgehoben und infolge Massenträgheit ein Gleiten der Auflage in der Buchse erreicht. Das Objekt ist somit zumindest auf einem der Bewegungselemente derart gelagert, daß auch senkrecht zur Bearbeitungs- oder Analysenebene des Objekts zugleich Mikro- und Makrobewegungen ausführbar sind. Dies ermöglicht eine Anpassung des Abstandes zwischen Bearbeitungs- und Analysenebene und Bearbeitungswerkzeug, beispielsweise die Einstellung des Abstandes zwischen zu bearbeitender oder zu analysierender Objektoberfläche und Abtastnadel eines RTMs, auch bei einer rauhen Objektoberfläche, deren Rauhigkeiten durch Mikrobewegungen allein durch Verformen des piezoelektrischen Materials nicht ausgleichbar sind, oder nach Auswechseln und Montage der Abtastnadel.

Die Auflage des Bewegungselementes ist im Bewegungselement selbst bewegbar gelagert, wobei zugleich eine Führung der Auflage am Bewegungselement vorgesehen ist. Zweckmäßig ist es, die Auflage in einer im Bewegungselement befestigten, axial verlaufenden Buchse zu lagern, so daß Reibkräfte zwischen einander angrenzenden Oberflächen von Auflage und Buchse eine Bewegung der Auflage in der Buchse verhindern. Die Reibkräfte sind so bemessen, daß sie einerseits zur Stütze des Objekts ausreichend sind und daß andererseits durch Anlegen von Spannungsfunktionen an das piezoelektrische Bewegungselement ein Gleiten der Auflage in der Buchse in axialer Richtung erreichbar ist. In dieser Ausführungsform der Erfindung ist die piezokeramische Ausbildung des Bewegungselementes senkrecht zur Bearbeitungs- oder Analysenebene sowohl für die Mikrobewegung als auch die Makrobewegung des Objekts ausnutzbar.

Eine rein mechanische Variante der Erfindung ist in Patentansprüchen 2 und 3 angegeben. Zumindest eines der Bewegungselemente des Mikromanipulators ist auf einem Teilstück der Basisplatte befestigt, das makrobeweglich ist. Gemäß der Erfindung ist das Teilstück gegen die Kraft einer Feder verstellbar, die einerseits an der Basisplatte, andererseits am Teilstück befestigt ist. Zum Verstellen des Teilstückes sind zwei Blattfedern aufeinanderliegend angeordnet, die gegeneinander spreizbar sind. Beim Spreizen der Blattfedern ändert sich der Abstand zwischen den Befestigungsstellen der Blattfedern an Basisplatte und Teilstück, so daß bei ortsfester Basisplatte das Teilstück bewegt wird. Wesentlich ist, daß sich durch das Spreizen der Blattfedern eine parabolische Abhängigkeit zwischen Spreizweg und Verstellung des Teilstücks ergibt, die Verstellbarkeit nimmt mit stärker werdender Spreizung der Blattfedern zu. Die Blattfedern sind deshalb am Teilstück so angeordnet, daß die Einstellempfindlichkeit zwischen Objekt und beispielsweise einer Abtastnadel eines RTMs mit fortschreitender Annäherung von Objekt und Abtastnadel erhöht wird.

Eine weitere Variante der Erfindung, bei der für die Makrobewegung ebenfalls die piezoelektrische Steuerung der Bewegungselemente genutzt wird, betreffen die Patentansprüche 4 und 5. Danach stützen die Bewegungselemente das Objekt oder den Objekthalter über eine zur Stützrichtung der Bewegungselemente schief verlaufende Stützebene ab, deren Normale einen Winkel zur Stützrichtung der Bewegungselemente aufweist. Die Stützebene ist schraubenförmig ausgebildet und wird von den Bewegungselementen in axialer Richtung abgestützt, so daß sich beim Rotieren der Stützebene die Bearbeitungs- oder Analysenebene axial verschiebt. Vorteilhaft ist es, die schraubenförmig verlaufende Stützebene in mehrere gleichartig gestaltete Abschnitte aufzuteilen, wobei jeder Abschnitt von einem der Bewegungselemente abgestützt wird.

Die zu wählende Größe des Winkels zwischen Normale der Stützebene und Stützrichtung der Bewegungselemente ist einerseits abhängig von der Leistungsfähigkeit der piezoelektrischen Bewegungselemente hinsichtlich ihrer seitlichen Auslenkbarkeit am Auflagepunkt, andererseits von den Reibungskräften, die an den Auflagepunkten der Bewegungselemente auf der Oberfläche der Stützebene herrschen. Um die Reibungskräfte gering zu halten, wird die Stützebene bevorzugt poliert. Eine Bewegung der Stützebene mittels der Bewegungselemente oder eine Bewegung des Mikromanipulators bei ortsfestem Objekt erfolgt durch Anlegen elektrischer Spannungsverläufe an der Piezokeramik der Bewegungselemente. Die Wahl des Winkels bestimmt das Maß der Verschiebung der zu bearbeitenden oder zu analysierenden Objektoberfläche senkrecht zur Bearbeitungs- oder Analysenebene, also beispielsweise senkrecht zur Abtastnadel des RTMs.

Die Erfindung wird im folgenden anhand von Ausführungsbeispielen näher erläutert. Die Zeichnung zeigt im einzelnen:
- Figur 1: Mikromanipulator mit einem Bewegungselement mit verstellbarer Auflage;
- Figur 1a: Längsschnitt eines Bewegungselementes mit verstellbarer Auflage, Ausschnitt;
- Figur 1b: Querschnitt eines Bewegungselementes nach Figur 1a gemäß Schnittlinie b/b;
- Figur 2: Mikromanipulator mit einem mechanisch bewegbaren Bewegungselement;
- Figur 3: Mikromanipulator nach Figur 2 mit einem mittels Blattfedern befestigtem Teilstück der Basisplatte;
- Figur 4: Mikromanipulator mit schiefer Stützebene;
- Figur 5: schraubenförmig verlaufende Stützebene eines Mikromanipulators;
- Figur 6: Mikromanipulator mit Stützebene mit schraubenförmig verlaufenden Abschnitten.

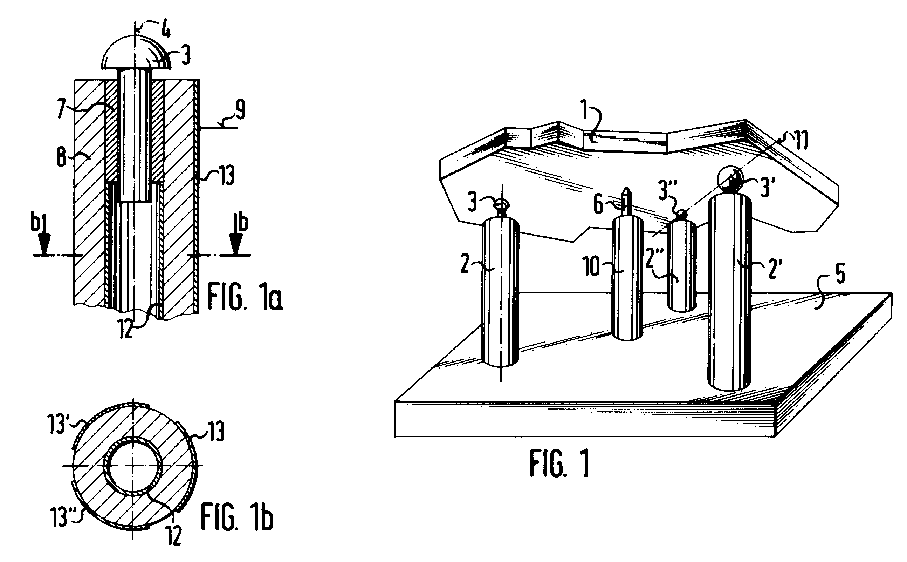

Figur 1 der Zeichnung zeigt einen Mikromanipulator zur Bewegung eines Objekts oder Objekthalters 1 mittels drei den Objekthalter stützenden Bewegungselementen 2, 2′, 2˝. Der Objekthalter liegt auf Auflagen 3, 3′, 3˝ der Bewegungselemente in stabiler Lage auf. Die im Ausführungsbeispiel zylindrischen Bewegungselemente 2, 2′, 2˝ sind mit senkrecht verlaufender Zylinderachse 4 auf einer Basisplatte 5 befestigt. Der Mikromanipulator dient zur Bewegung des Objekts relativ zu einer Abtastnadel 6, die im Ausführungsbeispiel zwischen den Bewegungselementen 2, 2′, 2˝ auf einem Bewegungselement 10 angeordnet und ebenfalls auf der Basisplatte 5 befestigt ist.

Im Ausführungsbeispiel handelt es sich um einen Mikromanipulator für ein RTM, wobei das Objekt 1 zur Abtastnadel 6 des RTM's im Nanobereich verschiebbar ist. Die Anordnung der Abtastnadel 6 auf dem Bewegungselement 10 auf der Basisplatte 5 zwischen den Bewegungselementen 2, 2′, 2˝ ist nicht zwingend. Die Abtastnadel mit dem Bewegungselement 10 läßt sich auch an anderer Stelle auf der Basisplatte befestigen. Wegen der nicht unbeachtlichen Temperaturdrift zwischen den Bewegungselementen 2, 2′, 2˝ und der Abtastnadel 6 bei einer Bearbeitung oder Analyse der Objektoberfläche mittels RTM ist jedoch die Anordnung von Bewegungselementen und Abtastnadel auf der gleichen Basisplatte von großem Vorteil.

Im Ausführungsbeispiel nach Figur 1 sind die Auflagen 3′, 3˝ starr mit den zugehörigen Bewegungselementen 2′, 2˝ verbunden. Die Auflage 3 des Bewegungselementes 2 ist dagegen beweglich angeordnet. Wie in Figur 1a gezeigt ist, ist die Auflage 3 in einer Buchse 7 innerhalb des Bewegungselementes 2, dessen piezoelektrisches Material 8 als Rohr ausgebildet ist, axial verlaufend eingesetzt. Im Ausführungsbeispiel ist die Buchse 7 in das piezoelektrische Material 8 eingebettet. Durch Anlegen von elektrischen Spannungsverläufen an das piezoelektrische Material über elektrische Leiter 9, läßt sich die Buchse durch Verformen des Materials gegenüber die Auflage verschieben. Dabei unterstützen Rammeffekte die Bewegung, insbesondere läßt sich die Auflage durch Stöße gegen Objekt oder Objekthalter versetzen. Die elektrischen Leiter 9 werden von einem Generator gespeist, der zur Erzeugung der gewünschten Steuerspannungen für die erforderlichen Verformungen des piezoelektrischen Materials dient. Der vorgenannte Generator ist in der Zeichnung nicht dargestellt.

Die Buchse 7 und die Auflage 3 sind so dimensioniert, daß zwischen ihren aneinandergrenzenden Oberflächen Reibkräfte herrschen, die die Auflage 3 bei aufgelegtem Objekt bzw. Objekthalter 1 in der Buchse 7 unverschieblich festhalten. Zum Verschieben der Auflage 3 werden am piezoelektrischen Material 8 solche Steuerspannungsimpulse angelegt, daß sich das piezoelektrische Material spontan axial streckt oder verkürzt und dabei die Haftreibungskräfte zwischen Buchse 7 und Auflage 3 überwindet, so daß sich die Auflage infolge ihrer Massenträgheit innerhalb des Bewegungselementes relativ zur Buchse verschiebt. Es lassen sich auf diese Weise sowohl Aufwärts- wie Abwärtsbewegungen der Auflage im Bewegungselement durchführen.

Bei einer Bewegung der Auflage 3 innerhalb des Bewegungselementes 2 verändert sich die Lage des Objekts 1 relativ zur Abtastnadel 6. Im Ausführungsbeispiel wird das Objekt 1 um eine Achse 11 gekippt, Figur 1, deren Lage von den ortsunverändert bleibenden Auflagen 3′, 3˝ der Bewegungselemente 2′, 2˝ vorgegeben ist. Mit dem Kippen des Objekts 1 um die Achse 11 wird eine Bewegung zwischen Abtastnadel und zu bearbeitender oder zu analysierender Objektoberfläche auch im Makrobereich erzeugt.

Soll statt der Kippbewegung eine parallele Bewegung des Objekts erreicht werden, ist es selbstverständlich möglich, alle Bewegungselemente 2, 2′, 2˝ mit einer beweglichen Auflage 3 auszurüsten. Das Objekt oder der Objekthalter lassen sich dann durch Anlegen entsprechender Steuerspannungsimpulse gleichmäßig bewegen.

Für die Mikrobewegung des Objekts sind die Bewegungselemente 2, 2′, 2˝ im Ausführungsbeispiel sämtlich hohlzylindrisch ausgebildet, wie dies in Figur 1a für das Bewegungselement 2, im Längsschnitt gezeigt ist. In Figur 1b ist ein Querschnitt des Bewegungselementes gemäß Schnittlinie b/b nach Figur 1a senkrecht zur Zylinderachse 4 wiedergegeben. Aus den Figuren ist ersichtlich, daß das piezoelektrische Material 8 auf seiner Innenseite mit einer Innenelektrode 12, auf seiner äußeren Seite mit Streifenelektroden 13, 13′, 13˝ bedeckt ist, die in Richtung der Zylinderachse 4 verlaufen. Werden an den Elektroden Spannungsverläufe angelegt, so lassen sich die Bewegungselemente in ihrer Länge verändern oder biegen. Gemäß der Erfindung bedarf es also nur der Regelung dieser Spannungsverläufe, um Objekt oder Objekthalter in jede Richtung zu bewegen, wobei Makrobewegungen durch schrittweise Addition von Mikrobewegungen auch senkrecht zur Bearbeitungs- oder Analyse-Ebene des Objekts erreicht werden.

Im Ausführungsbeispiel nach Figur 1a sind die für die senkrechte Bewegung des Objekts erforderlichen Elemente, nämlich bewegliche Auflage 3 und im piezoelektrischen Material 8 eingebettete Buchse 7, im Bewegungselement integriert. Diese Elemente können jedoch auch seperat angeordnet und mit dem Bewegungselement verbunden sein.

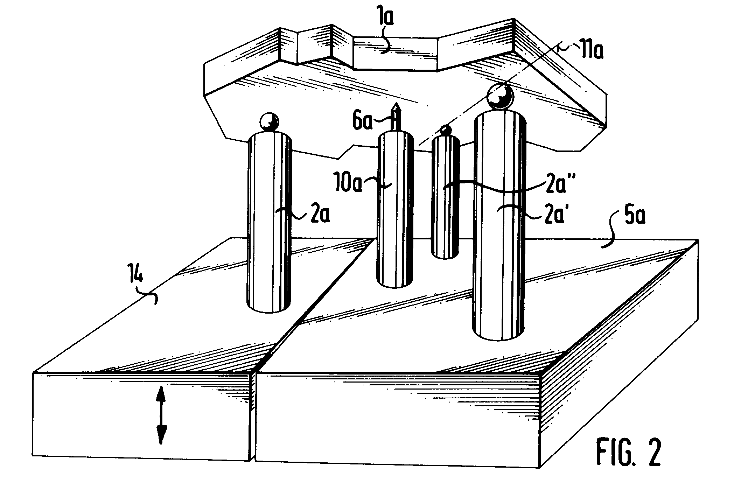

In Figur 2 ist ein Mikromanipulator wiedergegeben, bei dem eines der Bewegungselemente 2a, 2a′, 2a˝, im Ausführungsbeispiel das Bewegungselement 2a, auf einem relativ zur Basisplatte 5a beweglichen Teilstück 14 angeordnet ist. Bei Bewegung des Teilstückes 14, im Ausführusngsbeispiel ist eine Bewegung des Teilstücks senkrecht zur Oberfläche der Basisplatte 5a vorgesehen, wird der Objekthalter 1a des Mikromanipulators nach Figur 2 - analog zum Objekt 1 nach Figur 1 - um eine durch die Stützpunkte der Bewegungselemente 2a′, 2a˝ am Objekthalter 1a verlaufende Achse 11a gekippt.

Zur Mikrobewegung des Objekts sind die Bewegungselemente 2a, 2a′, 2a˝ in gleicher Weise wie Bewegungselemente 2, 2′, 2˝ nach Figur 1, 1a und 1b ausgebildet.

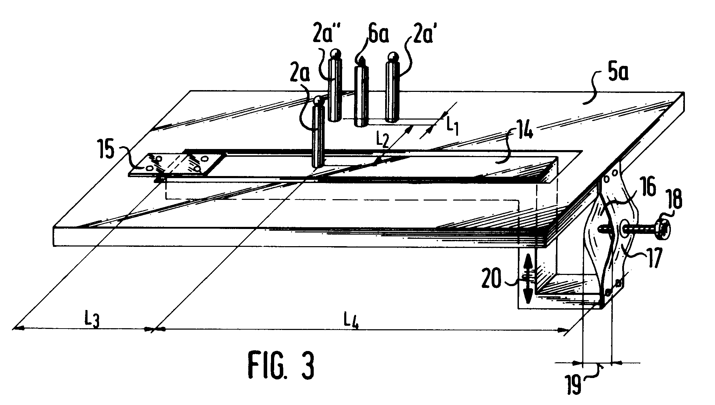

Ein zwischen Blattfedern an der Basisplatte 5a befestigtes Teilstück 14a zeigt Figur 3. Es ist an einem seiner Enden mit einer Blattfeder 15 an der Basisplatte 5a befestigt, mit dem anderen Ende über zwei Blattfedern 16, 17, die im entspannten Zustand aufeinanderliegend angeordnet sind, mit der Basisplatte 5a verbunden. Die Blattfedern 16, 17 lassen sich mittels einer Spannschraube 18 spreizen. Dabei nimmt der Verstellweg des Teilstücks 14 in Abhängigkeit vom Spreizabstand 19 zwischen den Blattfedern 16, 17 mit zunehmender Spreizung parabolisch zu. Die Blattfedern 16, 17 sind zwischen Basisplatte 5a und Teilstück 14 derart angeordnet, daß sich bei fortschreitender Annäherung von Objekt und Abtastnadel die Einstellempfindlichkeit des Teilstücks 14 beim Verstellen der Spannschraube 18 erhöht. Die Blattfedern 16, 17 sind hierzu im Ausführungsbeispiel nach Figur 3 parallel zur Verstellrichtung 20 des Teilstücks 14 zwischen Basisplatte und Teilstück angeordnet. Beim Spreizen der Blattfedern wird das Teilstück 14 gegen die Kraft der Blattfeder 15 angehoben, so daß sich Objekthalter und Objekt von der Abtastnadel abheben. Beim Absenken des Objekts durch Entspannen der Blattfedern 16, 17 nimmt die Einstellempfindlichkeit beim Verstellen der Spannschraube 18 mit geringer werdendem Abstand zwischen Objektoberfläche und Nadelspitze der Abtastnadel zu.

Das Untersetzungsverhältnis zwischen durch Spreizen der Blattfedern 16, 17 erzeugtem Verstellweg des Teilstücks und Abstand zwischen Objektoberfläche und Abtastnadel wird durch Wahl der Hebelverhältnisse L₁ : L₂, L₃ : L₄ sowie durch die Steigung des Schraubengewindes der Spannschraube 18 in weiten Grenzen variabel.

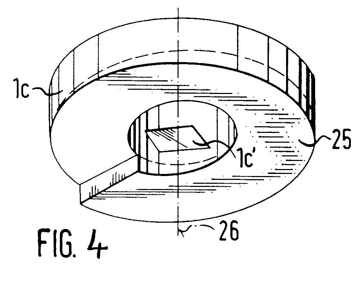

Figur 4 zeigt einen Objekthalter 1c mit schraubenförmig verlaufender Stützebene 25. Bei rotierender Bewegung der Stützebene 25 mittels in Figur 4 nicht dargestellter Bewegungselemente wird das im Objekthalter 1c zentral angeordnete Objekt 1c′ in Richtung der Schraubenachse 26 bewegt.

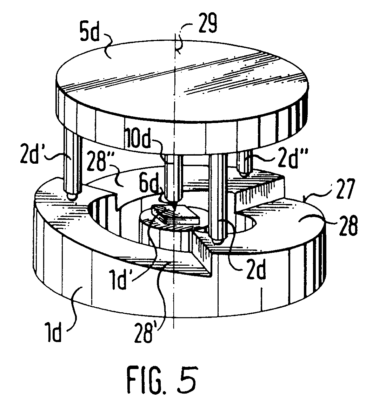

Einen mit einer ebenfalls schraubenförmigen Stützebene ausgerüsteteten Mikromanipulator zeigt Figur 5. Der Objekthalter 1d dieses Mikromanipulators weist eine Stützebene 27 auf, die aus mehreren, im Ausführungsbeispiel aus drei schraubenförmig verlaufenden Abschnitten 28, 28′, 28˝ besteht. Jeder der Abschnitte ist im Ausführungsbeispiel gleichartig ausgebildet, insbesondere weisen die Schraubenflächen jeweils eine gleiche Steigung auf, im Ausführungsbeispiel eine Steigung von 0,3 mm pro Abschnitt. Die Abschnitte 28, 28′, 28˝ werden jeweils von einem der Bewegungselemente 2d, 2d′, 2d˝ abgestützt. Im Ausführungsbeispiel ist der Objekthalter 1d ortsfest angeordnet und der Mikromanipulator auf der Stützebene frei beweglich. Der Mikromanipulator bewegt sich in Richtung einer Zentralachse 29, wenn die Bewegungselemente den Mikromanipulator über die Stützebene um die Zentralachse drehen. Im Objekthalter 1d ist das zu bearbeitende oder analysierende Objekt 1d′ zentral angeordnet. Die Objektoberfläche verläuft parallel zur Basisplatte 5d des Mikromanipulators, auf der in gleicher Weise wie in allen vorangegangenen Ausführungsbeispielen eine Abtastnadel 6d eines RTMs mit ihrem Bewegungselement 10d und den Bewegungselementen 2d, 2d′, 2d˝ befestigt ist. Bei Rotation des Mikromanipulators durch die Bewegungselemente wird der Abstand zwischen Objektoberfläche und Nadelspitze der Abtastnadel 6d verringert oder vergrößert.

Für die Einstellung des Abstandes zwischen zu bearbeitender oder zu analysierender Objektoberfläche sind in den Ausführungsbeispielen auch die Bewegungselemente 10 mit den Abtastnadeln piezoelektrisch beweglich.

## Patentansprüche

1. Mikromanipulator zur Bewegung eines Objekts relativ zu einer Bearbeitungs- oder Analysenposition zum Bearbeiten oder Analysieren von zumindest einem Teil der Objektoberfläche, mit zumindest einem das Objekt oder einen Objekthalter (1) stützenden, zur Ausführung von Mikrobewegungen piezoelektrisch verstellbaren Bewegungselement (2), das eine Auflage (3) für das Objekt oder den Objekthalter (1) aufweist, wobei durch Addition von Mikrobewegungen Makrobewegungen senkrecht zur Bearbeitungs- oder Analysenebene erzeugbar sind,
**dadurch gekennzeichnet**,
daß die Auflage (3) in einer am Bewegungselement (2) befestigten Buchse (7) so gelagert ist, daß Reibkräfte zwischen einander angrenzenden Oberflächen von Auflage (3) und Buchse (7) eine Bewegung verhindern und zur Stütze des Objekts oder des Objekthalters (1) ausreichend sind, und daß durch Anlegen von Spannungsfunktionen an das piezoelektrische Bewegungselement (2) die Haftreibungskräfte zwischen Auflage (3) und Buchse (7) aufgehoben und infolge Massenträgheit ein Gleiten der Auflage (3) in der Buchse (7) erreichbar ist.

2. Mikromanipulator zur Bewegung eines Objekts relativ zu einer Bearbeitungs- oder Analysenposition zum Bearbeiten oder Analysieren von zumindest einem Teil der Objektoberfläche, mit mehreren das Objekt oder einen Objekthalter (1a) stützenden, zur Ausführung von Mikrobewegungen piezoelektrisch verstellbaren Bewegungselementen (2a, 2a′, 2a˝), die auf einer Basisplatte (5a) befestigt sind und je eine Auflage für das Objekt oder den Objekthalter (1a) aufweisen,
**dadurch gekennzeichnet**,
daß zumindest eines der Bewegungselemente (2a) auf einem gegen die Kraft einer Feder (15) gegenüber der Basisplatte (5a) bewegbaren Teilstück (14) angeordnet ist, daß die Feder (15) einerseits an der Basisplatte (5a), andererseits an einem Ende des Teilstücks (14) befestigt ist, und daß das Teilstück (14) zu seiner Verstellung gegen die Federkraft der Feder (15) mit seinem anderen Ende an der Basisplatte (5a) über zwei Blattfedern (16, 17) befestigt ist, die im entspannten Zustand parallel zur Verstellrichtung des Teilstücks (14) aufeinanderliegen und zur Verstellung gegeneinander spreizbar sind.

3. Mikromanipulator nach Anspruch 2,
**dadurch gekennzeichnet**, daß zum Spreizen der Blattfedern (16, 17) eine Spannschraube (18) vorgesehen ist.

4. Mikromanipulator zur Bewegung eines Objekts relativ zu einer Bearbeitungs- oder Analysenposition zum Bearbeiten oder Analysieren von zumindest einem Teil der Objektoberfläche, mit mehreren das Objekt oder einen Objekthalter (1d) stützenden, zur Ausführung von Mikrobewegungen piezoelektrisch verstellbaren Bewegungselementen (2d, 2d′, 2d˝), die je eine Auflage für das Objekt oder den Objekthalter (1d) aufweisen,
**dadurch gekennzeichnet**,
daß die Bewegungselemente (2, 2′, 2˝) in axialer Richtung eine schraubenförmig verlaufende Stützebene (25, 27) abstützen.

5. Mikromanipulator nach Anspruch 4,
**dadurch gekennzeichnet**,
daß die schraubenförmig verlaufende Stützebene (27) in mehrere gleichartig gestaltete Abschnitte (28, 28′, 28˝) aufgeteilt ist, wobei jeder der Abschnitte (28, 28′, 28˝) jeweils von zumindest einem der Bewegungselemente (2d, 2d′, 2d˝) abgestützt wird.

## Claims

1. Micromanipulator for moving an object relative to a processing or analysis position for processing or analysis of at least a part of the object surface, having at least one moving element (2) which supports the object or an object holder (1), can be displaced piezoelectrically in order to carry out micro-movements and has a support (3) for the object or the object holder (1), it being possible to produce macro-movements, at right angles to the processing or analysis plane, by addition of micro-movements, characterized in that the support (3) is mounted in a bush (7), which is attached to the moving element (2), such that friction forces between mutually adjacent surfaces of the support (3) and the bush (7) prevent any movement and are sufficient to support the object or the object holder (1), and in that the adhesive friction forces between the support (3) and the bush (7) are cancelled by applying voltage functions to the piezoelectric moving element (2), and it being possible to achieve sliding of the support (3) in the bush (7) as a result of inertia.

2. Micromanipulator for moving an object relative to a processing or analysis position for processing or analysis of at least a part of the object surface, having a plurality of moving elements (2a, 2a′, 2a˝) which support the object or an object holder (1a), can be displaced piezoelectrically in order to carry out micro-movements, are secured on a baseplate (5a) and each have a support for the object or the object holder (1a), characterized in that at least one of the moving elements (2a) is arranged on a partial element (14) which can move with respect to the baseplate (5a) against the force of a spring (15), in that the spring (15) is attached at one end to the baseplate (5a) and at the other end to one end of the partial element (14), and in that the partial element (14) is fastened by its other end to the baseplate (5a) via two leaf springs (16, 17) in order to displace said partial element (14) against the spring force of the spring (15), which leaf springs (16, 17) rest on one another, parallel to the displacement direction of the partial element (14), in the unstressed state and can be spread apart from one another for displacement.

3. Micromanipulator according to Claim 2, characterized in that a clamping screw (18) is provided for spreading the leaf springs (16, 17).

4. Micromanipulator for moving an object relative to a processing or analysis position for processing or analysis of at least a part of the object surface, having a plurality of moving elements (2d, 2d′, 2d˝) which support the object or an object holder (1d), can be displaced piezoelectrically in order to carry out micro-movements and each have a support for the object or the object holder (1d), characterized in that the moving elements (2, 2′, 2˝) support a supporting plane (25, 27), which runs in a helical shape, in the axial direction.

5. Micromanipulator according to Claim 4, characterized in that the supporting plane (27), which runs in a helical shape, is divided into a plurality of identically designed sections (28, 28′, 28˝), each of the sections (28, 28′, 28˝) being supported in each case by at least one of the moving elements (2d, 2d′, 2d˝).

## Revendications

1. Micromanipulateur pour déplacer un objet par rapport à une position d'usinage ou d'analyse pour l'usinage ou l'analyse d'au moins une partie de la surface de l'objet, comportant au moins un élément de déplacement (2), qui soutient l'objet ou un porte-objet (1) et est réglable et déplaçable par voie piézoélectrique pour l'exécution de microdéplacements, et qui possède un support (3) pour l'objet ou le porte-objet (1), des macrodéplacements pouvant être produits perpendiculairement au plan d'usinage ou d'analyse sous l'effet de l'addition de microdéplacements,
caractérisé en ce que le support (3) est monté dans une douille (7) fixée à l'élément de déplacement (2) de sorte que des forces de frottement agissant entre des surfaces, qui sont réciproquement adjacentes, du support (3) et de la douille (7) empêchent un déplacement et sont suffisantes pour supporter l'objet ou le porte-objet (1), et que sous l'effet de l'application de fonctions de tension à l'élément de déplacement piézoélectrique (2), les forces de frottement par adhérence entre le support (3) et la douille (7) sont supprimées et, en fonction de l'inertie de masse, on peut obtenir un glissement du support (3) dans la douille (7).

2. Micromanipulateur pour déplacer un objet par rapport à une position d'usinage ou d'analyse pour l'usinage ou l'analyse d'au moins une partie de la surface de l'objet, comportant plusieurs éléments de déplacement (2a,2a′,2a˝), qui supportent l'objet ou un porte-objet (1a) et sont déplaçables par voie piézoélectrique pour l'exécution de microdéplacements et qui sont fixés sur une plaque de base (5a) et possèdent respectivement un support pour l'objet ou le porte-objet (1a),
caractérisé par le fait qu'au moins l'un des éléments de déplacement (2a) est disposé sur une pièce (14) qui est déplaçable par rapport à la plaque de base (5a) à l'encontre de la force d'un ressort (15), que le ressort (15) est fixé d'une part à la plaque de base (5a) et d'autre part à une extrémité de la pièce (14) et que pour son déplacement à l'encontre de la force de ressort (15), la pièce (14) est fixée, par son autre extrémité, à la plaque de base (5a) par l'intermédiaire de deux ressorts à lames (16,17), qui, à l'état détendu, s'appliquent l'un sur l'autre parallèlement à la direction de déplacement de la pièce (14) et peuvent être écartés pour leur déplacement réciproque.

3. Micromanipulateur selon la revendication 2, caractérisé en ce qu'une vis de serrage (18) est prévue pour l'écartement des ressorts à lames (16,17).

4. Micromanipulateur pour déplacer un objet par rapport à une position d'usinage ou d'analyse pour l'usinage ou l'analyse d'au moins une partie de la surface de l'objet, comportant plusieurs éléments de déplacement (2d,2d′,2d˝), qui supportent l'objet ou un porte-objet (1d) et sont déplaçables par voie piézoélectrique pour l'exécution de microdéplacements et qui possèdent respectivement un support pour l'objet ou le porte-objet (1d), caractérisé en ce que les éléments de déplacement (2,2′,2˝) supportent, dans une direction axiale, un plan de support (25,27) de forme hélicoïdale.

5. Micromanipulateur selon la revendication 4, caractérisé en ce que le plan d'appui de forme hélicoïdale (27) est subdivisé en plusieurs sections (28,28′,28˝) conformées de la même manière, chacune des sections (28, 28′,28˝) étant supportée respectivement par au moins l'un des éléments de déplacement (2d,2d′,2d˝).
